Europäisches Patentamt

European Patent Office

Office européen des brevets

(19)

(11) **EP 0 485 202 B1**

# (12) EUROPEAN PATENT SPECIFICATION

(45) Date of publication and mention
of the grant of the patent:
**27.03.1996 Bulletin 1996/13**

(51) Int Cl.[6]: **G01R 31/302**, G01R 31/28

(21) Application number: **91310287.7**

(22) Date of filing: **06.11.1991**

(54) **Use of STM-like system to measure node voltage on integrated circuits**

Anwendung eines STM-artigen Systems zur Messung der Knotenspannung in integrierten Schaltungen

Utilisation d'une système du type STM pour mesurer le tension de noeux dans des circuits intégrés

(84) Designated Contracting States:
**DE FR GB IT NL**

(30) Priority: **06.11.1990 US 609987**
**27.12.1990 US 634842**

(43) Date of publication of application:
**13.05.1992 Bulletin 1992/20**

(73) Proprietor: **TEXAS INSTRUMENTS**
**INCORPORATED**
**Dallas Texas 75265 (US)**

(72) Inventors:
  • **Aton, Thomas J.**
    **Dallas, Texas 75248-4216 (US)**
  • **Moslehi, Mehrdad M.**
    **Dallas, Texas 75248 (US)**
  • **Matthews, Robert T.**
    **Plano, Texas 75075 (US)**

• **Davis, Cecil J.**
  **Greenville, Texas 75401 (US)**

(74) Representative:
**Blanco White, Henry Nicholas et al**
**ABEL & IMRAY**
**Northumberland House**
**303-306 High Holborn**
**London WC1V 7LH (GB)**

(56) References cited:
**EP-A- 0 196 475        EP-A- 0 223 918**

• **APPLIED PHYSICS LETTERS. vol. 50, no. 19, 11 May 1987, NEW YORK US pages 1352 - 1354; P. MURALT ET AL.: 'SCANNING TUNNELING MICROSCOPY AND POTENTIOMETRY ON A SEMICONDUCTOR HETEROJUNCTION'**
• **APPLIED PHYSICS LETTERS. vol. 53, no. 6, 8 August 1988, NEW YORK US pages 487 - 489; S. HOSAKA ET AL.: 'OBSERVATION OF PN JUNCTIONS ON IMPLANTED SILICON USING A SCANNING TUNNELING MICROSCOPE'**
• **PATENT ABSTRACTS OF JAPAN vol. 13, no. 524 (P-964)22 November 1989**

## Description

## BACKGROUND OF THE INVENTION

1. Field of the Invention

This invention relates in general to the evaluation of integrated circuits, and is specifically related to an apparatus for measuring node voltage on an integrated circuit.

2. Description of the Related Art

As the demand for and complexity of integrated circuits increases, it becomes necessary to find more efficient and less expensive ways to evaluate integrated circuits. Measuring internal node voltages is an integral part of evaluating integrated circuits. One conventional method of measuring node voltages is with the use of needle probes. Needle probes are low capacitance probes which are set down on the integrated circuit such that each needle probe physically contacts a node of the integrated circuit which is to be measured. However, because the needle probes need to actually contact a node to measure its voltage, the metal line which forms the node may become damaged by contact with the probe. Furthermore, the probe itself will load the node and result in a distorted reading.

Another conventional method of measuring internal node voltages is Electron Beam Testing. Accurate Electron Beam Testers require an electron beam which is usually produced by a Scanning Electron Microscope (SEM) in a vacuum. In operation, the electron beam is focused onto a node of the integrated circuit thereby creating low energy secondary electrons. The energy of the secondary electrons is modulated by the surface potential of the sample. A positive voltage on the node attracts the secondary electrons. Consequently, the electrons slow down. A negative voltage on the node repels the electrons and consequently, the electrons speed up. Usually a specialized secondary electron detector is required to measure the average energy of the secondary electrons. Low average energy indicates slow moving electrons and a positive voltage on the node. On the other hand, a high average energy indicates fast moving electrons and a negative voltage. Accordingly, the relative voltage of the node can be determined by the level of average energy.

There are, however, several undesirable limitations associated with Electron Beam Testing. First, measurements must be taken in a vacuum as air molecules impede the measurement. Second, an Electron Beam Tester requires a significant amount of hardware, especially that required to maintain a vacuum. Accordingly, an Electron Beam Tester is expensive. Finally, Electron Beam Testing is only sensitive to approximately 10-30 mV. Sensitivity to millivolts or even microvolts is desirable.

Applied Physics Letters, vol. 50 no. 19, 11th May 1987, pages 1352-1354, on which the preamble of claim 1 is based, describes an apparatus and method for measuring a local voltage on a semiconductor device by an adaptation of scanning tunneling microscopy. A sensing needle is held at earth potential and a combined AC and DC voltage is applied to the sample device. The AC tunneling current is used to measure, and hence to control, the distance between the needle and the sample. The DC current is regulated to zero and the DC voltage is then used as an indication of the voltage of the contact point on the sample relative to the point of application of the voltage to the sample. JP-A 1-214769 discloses an apparatus in which a pointed probe is held at a constant distance from a sample, the field emission current is kept constant by a feedback mechanism, and changes in the probe voltage are read as representing changes in the sample voltage.

It is therefore an object of this invention to provide an apparatus which can measure node voltage in air.

It is further an object of this invention to provide such an apparatus which is sensitive to at least mV.

It is still further an object of this invention to provide such an apparatus which does not damaqe the integrated circuit.

It is still further an object of this invention to provide such an apparatus which is also inexpensive.

The invention provides an apparatus for measuring the potential at a node on an integrated circuit without contact to the integrated circuit, comprising: a conductive sensing needle to be positioned at a predetermined distance above said node; an adjustable voltage source for supplying a voltage to said sensing needle such that the potential difference between the sensing needle and the node gives rise to a current at a reference current level between said sensing needle and said node; a current detector for detecting said current, said current detector providing a deviation signal indicating the deviation of said current from said reference current, said deviation signal being provided to said adjustable voltage source to adjust the voltage applied between said sensing needle and said node to maintain said current at said reference current; and a voltage meter for measuring the voltage supplied by said adjustable voltage source, said voltage meter providing a signal indicating the voltage level of said node plus the voltage required to cause said current to flow; characterised in that it comprises a positioning circuit responsive to the atomic force between the sensing needle and the node for maintaining the sensing needle at said predetermined distance above the node.

In the drawings:

Figure 1 is a schematic diagram of an apparatus for measuring node voltage according to the invention.

Figures 2a-e are schematic diagrams of a prior art apparatus for fixing the distance between a sensing needle and an integrated circuit during various stages of operation.

Figure 3 is a schematic diagram of an apparatus for measuring node voltage including a sample and hold circuit, according to the invention.

## DETAILED DESCRIPTION OF THE PREFERRED EMBODIMENT OF THE INVENTION

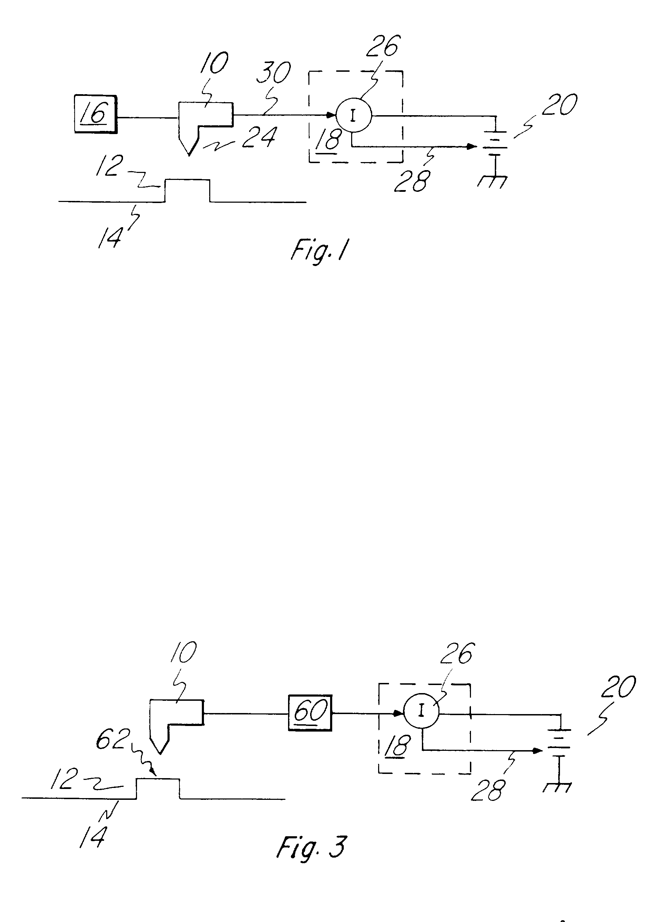

Referring to Figure 1, a sensing needle 10 is positioned above node 12 of an integrated circuit 14 so that the voltage on node 12 may be measured. The distance between sensing needle 10 and node 12 is fixed to allow tunneling current, or alternatively field emission current, (i.e. current 30) to flow between node 12 and sensing needle 10. Current 30 is a function of the potential difference and distance between sensing needle 10 and node 12. Voltage control circuit 18 is connected between sensing needle 10 and supply voltage 20 to detect a change in current 30. Responsive to a detected change in current 30, voltage control circuit 18 also generates feedback signal 28 to adjust supply voltage 20 so that current 30 returns to its initial value. When current 30 has returned to its initial value, the change in supply voltage 20 equals the change in voltage level on node 12. Accordingly, the change in voltage level on node 12 is determined by recording the change in voltage level of supply voltage 20.

Integrated circuit 14 is a device under test wich may be evaluated in either wafer or packaged form. To evaluate integrated circuit 14, external connections (not shown) are made to integrated circuit 14 as required for operation. The number and type of external connection required will depend on the individual integrated circuit under test. External connection methods, such as wire bonding, will be obvious to those skilled in the art. Typically, integrated circuit 14 contains a variety of nodes 12 from wich voltage can be measured during operation. Nodes 12 generally consist of metal or semiconductor material. For example, node 12 may consist of an interconnect line or a source or drain region of a transistor. Other examples of node 12 will be obvious to those skilled in the art.

Sensing needle 10 is similar to those used in traditional Scanning Tunneling Microscope (STM) technology. Typically, sensing needle 10 consists of conductive material such as tungsten and has a sharp cone-shaped tip 24 on the lower end which is placed over node 12 to generate tunneling current. Alternatives, such as attracting field emission current, will be obvious to those skilled in the art and are considered within the scope of the present invention. Tip 24 is typically no more than 3 or 4 atoms wide and can be as narrow as one atom wide. Consequently, no limitations are placed on the width of node 12 by the present invention, and accordingly, the width of node 12 may be determined by device fabrication limits.

Voltage control circuit 18 generally consists of current detector 26 and feedback signal 28. Current detector 26 is connected between sensing needle 10 and supply voltage 20 to detect a change in current 30. Feedback signal 28 is connected to supply voltage 20 in order to adjust supply voltage 20 responsive to a change in current 30. The accuracy to which the present invention can measure voltage depends on the degree of sensitivity of current detector 26. Sensitivity to 1 microvolt is possible. Circuitry for sensing the current changes, such as current detector 26, are well known and will be obvious to those skilled in the art.

Supply voltage 20 is an adjustable voltage supply which supplies voltage to sensing needle 10. Supply voltage 20 is connected to sensing needle 10 via voltage control circuit 18. The voltage level of supply voltage 20 is adjusted according to feedback signal 28 to mirror changes in the voltage level of node 12.

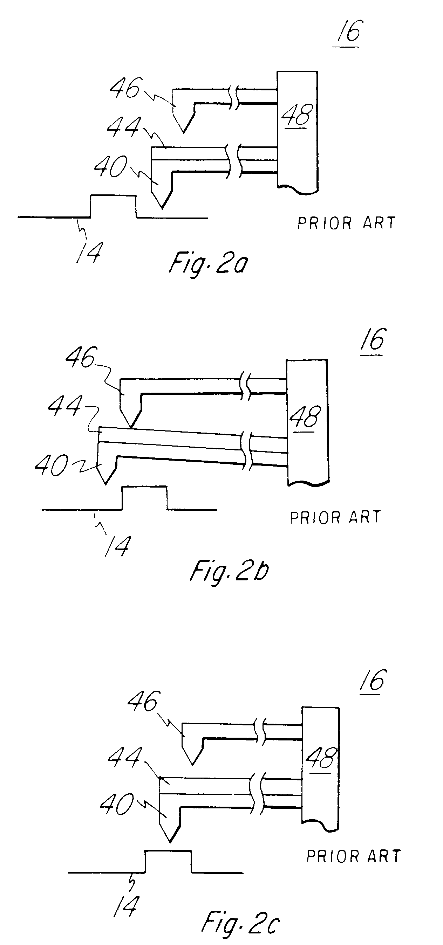

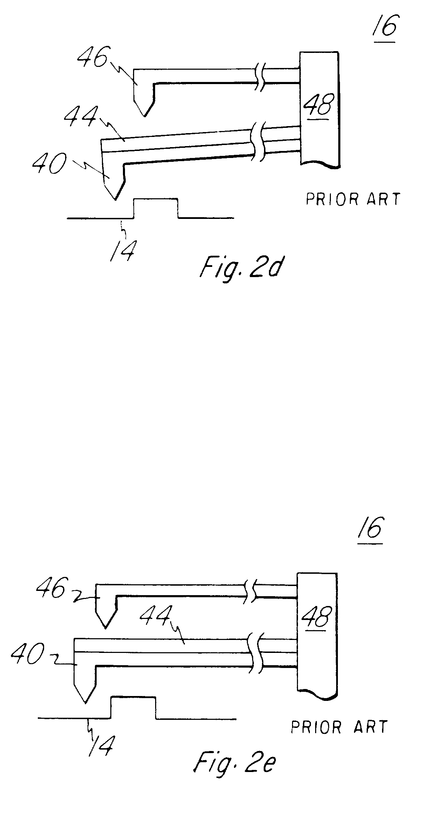

In operation, sensing needle 10 is positioned approximately one nanometer above node 12 of integrated circuit 14. Because sensing needle 10 never contacts node 12, integrated circuit 14 is not damaged by the measurement, unlike some prior art techniques. One method of positioning sensing needle 10 uses traditional Atomic Force Microscope (AFM) technology. Referring to Figure 2a, positioner 16 consists of lower arm 40, metal layer 44 which covers lower arm 40, upper arm 46 located above metal layer 44, and piezoelectric z-drive 48 which is connected to both lower arm 40 and upper arm 46. Lower arm 40 is positioned over integrated circuit 14. As the surface of integrated circuit 14 rises, lower arm 40 is repelled, as shown in Figure 2b. As a result metal layer 44 moves closer to upper arm 46 and the tunneling current between upper arm 46 and metal layer 44 increases. Responsive to the increased current, piezoelectric z-drive raises both upper arm 46 and lower arm 40 until the tunneling current between upper arm 46 and metal layer 44 returns to its initial value, as shown in Figure 2c. Conversely, as the surface of integrated circuit 14 falls, lower arm 40 also falls, as shown in Figure 2d. As a result metal layer 44 moves farther away from upper arm 46 and the tunneling current between upper arm 46 and metal layer 44 decreases. Responsive to the decreased current, piezoelectric z-drive lowers both upper arm 46 and lower arm 40 until the tunnating current returns to its initial value, as shown in Figure 2e. As a result, sensing needle 10 maintains a fixed distance above integrated circuit 14.

With sensing needle 10 positioned above node 12, supply voltage 20 is set to an initial voltage level. (Of course, supply voltage 20 may alternatively be set prior to positioning sensing needle 10.) Generally, supply voltage 20 is set such that the potential difference between sensing needle 10 and node 12 is small. The potential difference between sensing needle 10 and node 12 will cause electrons to tunnel across the gap and produce tunneling current, current 30, in sensing needle 10. One advantage of detecting tunneling current is that a vacuum is not required for accurate measurement. Air molecules do not affect the tunneling electrons because the air molecules are large compared to the distance between sensing needle 10 and node 12 (i.e. the distance the electron must tunnel).

Alternatively, field emission current may be detected. However, a vacuum is required when detecting field emission current. In this case, the field of either sensing needle 10 or node 12, whichever is more negative, will take electrons from the electric field of the other and produce a field emission current in sensing needle 10.

Regardless of whether current 30 is produced by tunneling or field emission current, current 30 is a function of the potential difference between node 12 and sensing needle 10, and the distance between node 12 and sensing needle 10. Current 30 can be determined from the following node voltage equation:

$$Vs - IR - Vn = 0$$

Where,

Vs is the voltage level of supply voltage 20;
Vn is the voltage level on node 12;
R is the tunneling resistance which increases as the distance between sensing needle 10 and node 12 increases and the resistance of sensing needle 10; and
I is current 30.

Rearranging the terms:

$$I = (Vs - Vn)/R$$

Accordingly, current 30 will be affected if either supply voltage 20, the voltage level on node 12, or the distance between sensing needle 10 and node 12 changes.

In the present invention (shown in Figure 1), the distance between sensing needle 10 and node 12 is fixed and the voltage is measured. Current 30 has an initial value corresponding to an initial potential difference between sensing needle 10 and node 12. Assuming the voltage on sensing needle 10 is more positive than the voltage on node 12, the potential difference between sensing needle 10 and node 12 decreases as the voltage on node 12 increases. Consequently, current 30 also decreases. The decrease in current is detected by current detector 26 and feedback signal 28 is generated to increase supply voltage 20 until current 30 returns to its initial value. When current 30 has returned to its initial value, the increase in supply voltage 20, and therefore the increase in voltage on sensing needle 10, equals the increase in the voltage on node 12.

As the voltage on node 12 decreases, the potential difference between sensing needle 10 and node 12 increases, as does current 30. The increase in current is detected by current detector 26 and feedback signal 28 is generated to decrease supply voltage 20 until current 30 returns to its initial value. When current 30 has returned to its initial value, the decrease in supply voltage 20, and therefore the decrease in voltage on sensing needle 10, equals the decrease in the voltage on node 12. Accordingly, the voltage on node 12 is determined by recording supply voltage 20.

It will be obvious to those skilled in the art that the voltage on sensing needle 10 may alternatively be set less positive than the voltage on node 12. In this case, current 30 will increase with an increase in voltage level on node 12. Consequently, supply voltage 20 must be increased to return current 30 to its initial value. When the voltage level on node 12 decreases, the current 30 decreases and supply voltage 20 must be decreased to return current 30 to its initial value. As was the case above, the increase or decrease in supply voltage 20 will equal the increase or decrease in the voltage level of node 12.

If desired, a sample and hold circuit 60 may be inserted between sensing needle 10 and voltage control circuit 18 to increase the bandwidth of the system. Referring to Figure 3, photon beam 62 is focused on to node 12. Alternatively, an ion or electron beam may be used. If the distance between sensing needle 10 and node 12 was too large to have much current, a current will be produced by photon beam 62 which in a sampling mode will allow the system to respond with the speed characteristics of photon beam 62. The bandwidth of the system can be very large since very short pulses of light (on the order of a picosecond) are possible.

Sample and hold circuit 60 can operate either in phase with the signal on node 12 or phase-shifted to monitor the entire waveform. In either case, current detector 26 and feedback signal 28 operate in the same manner as before except that sample and hold circuit 60 is inserted between current detector 26 and sensing needle 10. In other words, current detector 26 and feedback signal 28 respond to the sampled signal rather than the voltage level of node 12.

Changes in the details of the embodiments may be made. Such changes will include variations to the sensitivity of the measurements described herein.

**Claims**

1. An apparatus for measuring the potential at a node (12) on an integrated circuit (14) without contact to the integrated circuit, comprising: a conductive sensing needle (10) to be positioned at a predetermined distance above said node (12); an adjustable voltage source (20) for supplying a voltage to said sensing needle (10) such that the potential difference between the sensing needle (10) and the node (12) gives rise to a current at a reference current level between said sensing needle (10) and said node (12); a current detector (26) for detecting said current, said current detector (26) providing a deviation signal (28) indicating the deviation of said current from said reference current, said deviation signal being provided to said adjustable voltage source (20) to adjust the voltage applied between said sensing needle (10) and said node (12) to maintain said current at said reference current; and a voltage meter for measuring the voltage supplied by said adjustable voltage source (20), said voltage meter providing a signal indicating the voltage level of said node (12) plus the voltage required to cause said current to flow; characterised in that it comprises a positioning circuit (16) responsive to the atomic force between the sensing needle (10) and the node (12) for maintaining the sensing needle (10) at said predetermined distance above the node (12).

2. Apparatus as claimed in claim 1, wherein said sensing needle (10) comprises tungsten.

3. Apparatus as claimed in claim 1 or claim 2, wherein said predetermined distance is fixed to allow said sensing needle (10) to collect tunneling current from said node (12).

4. Apparatus as claimed in claim 1 or claim 2, wherein said predetermined distance is fixed to allow said sensina needle (10) to collect field emission current from said node (12).

5. Apparatus as claimed in any preceding claim, wherein said positioning circuit (16) comprises:

a) a first sensing arm (40) to be maintained at said predetermined distance above said integrated circuit (14);
b) a metal layer (44) located over said first sensing arm (40);
c) a second sensing arm (46) above said first sensing arm (40) for a sensing current between said second sensing arm and said metal layer (44); and
d) a z-drive (48) for adjusting the height of the first and second sensing arms (40, 44).

6. Apparatus as claimed in any preceeding claim, comprising:

a) a sample and hold circuit (60) connected between said sensing needle (10) and said adjustable voltage source (20); and
b) a beam (62) focused on said integrated circuit (14) for assisting injection of said current into said sensing needle (10).

7. Apparatus as claimed in claim 6, wherein said beam (62) comprises a photon beam.

8. Apparatus as claimed in claim 6, wherein said beam (62) comprises an electron beam.

9. Apparatus as claimed in claim 6, wherein said beam (62) comprises an ion beam.

## Patentansprüche

1. Vorrichtung zum Messen des Potentials an einem Knoten (12) an einer integrierten Schaltung (14) ohne Kontakt mit der integrierten Schaltung, umfassend:

eine leitende Abtastnadel (10), welche unter vorbestimmtem Abstand oberhalb des Knotens (12) zu positionieren ist;
eine einstellbare Spannungsquelle (20) zum Zuführen einer Spannung an die Abtastnadel (10), so daß die Potentialdifferenz zwischen der Abtastnadel (10) und dem Knoten (12) zu einem Strom auf einem Referenzstrompegel zwischen der Abtastnadel (10) und dem Knoten (12) Anlaß gibt;
einen Stromdetektor (26) zum Detektieren des Stroms, wobei der Stromdetektor (26) ein Abweichungssignal (28) zum Anzeigen der Abweichung des Stroms von dem Referenzstrom liefert, wobei das Abweichungssignal der einstellbaren Spannungsquelle (20) zum Einstellen der Spannung zugeführt wird, die zwischen der Abtastnadel (10) und dem Knoten (12) angelegt ist, um den Strom auf dem Referenzstrom zu halten; und
eine Spannungsmeßeinrichtung zum Messen der Spannung, die der einstellbaren Spannungsquelle (20) zugeführt wird, wobei die Spannungsmeßeinrichtung ein Signal zum Anzeigen des Spannungspegels des Knotens (12) plus der Spannung, die erforderlich ist, um zu veranlassen, daß der Strom fließt, liefert; dadurch gekennzeichnet, daß sie eine Positionierschaltung (16) umfaßt, die auf die atomare Kraft zwischen der Abtastnadel (10) und dem Knoten (12) anspricht, um die Abtastnadel (10) unter dem vorbestimmten Abstand oberhalb des Knotens (12) zu halten.

2. Vorrichtung nach Anspruch 1, dadurch gekennzeichnet, daß die Abtastnadel (10) Wolfram enthält.

3. Vorrichtung nach Anspruch 1 oder 2, dadurch gekennzeichnet, daß der vorbestimmte Abstand fest ist, um zu erlauben, daß die Abtastnadel (10) einen Tunnelstrom von dem Knoten (12) sammelt.

4. Vorrichtung nach Anspruch 1 oder Anspruch 2, dadurch gekennzeichnet, daß der vorbestimmte Abstand fest ist, um zu erlauben, daß die Abtastnadel (10) einen Feldemissionsstrom von dem Knoten (12) sammelt.

5. Vorrichtung nach einem der vorhergehenden Ansprüche, dadurch gekennzeichnet, daß die Positionierschaltung (16) umfaßt:

a) einen ersten Abtastarm (40), der unter dem vorbestimmten Abstand oberhalb der integrierten Schaltung (14) zu halten ist;

b) eine Metallschicht (44), die sich über dem ersten Abtastarm (40) befindet;

c) einen zweiten Abtastarm (46) oberhalb des ersten Abtastarms (40) für einen Abtaststrom zwischen dem zweiten Abtastarm und der Metallschicht (44); und

d) einen z-Antrieb (48) zum Einstellen der Höhe des ersten und zweiten Abtastarms (40, 44).

6. Vorrichtung nach einem der vorhergehenden Ansprüche, umfassend:

a) eine Abtast- und Halte-Schaltung (60), die zwischen der Abtastnadel (10) und der einstellbaren Spannungsquelle (20) angeschlossen ist; und

b) einen Strahl (62), der auf die integrierte Schaltung (14) fokussiert ist, zum Unterstützen einer Injektion des Stroms in die Abtastnadel (10).

7. Vorrichtung nach Anspruch 6, dadurch gekennzeichnet, daß der Strahl (62) einen Photonenstrahl umfaßt.

8. Vorrichtung nach Anspruch 6, dadurch gekennzeichnet, daß der Strahl (62) einen Elektronenstrahl umfaßt.

9. Vorrichtung nach Anspruch 6, dadurch gekennzeichnet, daß der Strahl (62) einen Ionenstrahl umfaßt.

**Revendications**

1. Dispositif pour mesurer le potentiel en un noeud (12) d'un circuit intégré (14) sans contact avec le circuit intégré, comprenant : une aiguille conductrice de détection (10) destinée à être positionnée à une distance prédéterminée au-dessus dudit noeud (12); une source de tension réglable (20) pour appliquer une tension à ladite aiguille de détection (10) de sorte que la différence de potentiel entre l'aiguille de détection (10) et le noeud (12) fait apparaître un courant situé à un niveau de référence de courant entre ladite aiguille de détection (10) et ledit noeud (12); un détecteur de courant (26) pour détecter ledit courant, ledit détecteur de courant (26) délivrant un signal d'écart (28) indiquant l'écart entre ledit courant et ledit courant de référence, ledit signal d'écart étant envoyé à ladite source dc tension réglable (20) pour régler la tension appliquée entre l'aiguille de détection (10) et le noeud (12) de manière à maintenir ledit courant à ladite valeur de référence; et un voltmètre pour mesurer la tension appliquée par ladite source de tension réglable (20), ledit voltmètre délivrant un signal indiquant le niveau de tension dudit noeud (12) plus la tension requise pour amener ledit courant à circuler; caractérisé en ce qu'il comprend un circuit de positionnement (16) apte à répondre à la force atomique entre l'aiguille de détection (10) et le noeud (12) pour maintenir l'aiguille de détection (10) à ladite distance prédéterminée au-dessus du noeud (12).

2. Dispositif selon la revendication 1, dans lequel ladite aiguille de détection (10) comporte du tungstène.

3. Dispositif selon la revendication 1 ou 2, dans lequel ladite distance prédéterminée cet fixée de manière à permettre à ladite aiguille de détection (10) de collecter un courant produit par effet tunnel à partir dudit noeud (12).

4. Dispositif selon la revendication 1 ou 2, dans lequel ladite distance prédéterminée est fixée de manière à permettre à ladite aiguille de détection (10) de collecter un courant d'émission de champ à partir dudit noeud (12).

5. Dispositif selon l'une quelconque des revendications précédentes, dans lequel ledit circuit de positionnement (16) comprend :

a) un premier bras de détection (40) destiné à être maintenu à ladite distance prédéterminée au-dessus dudit circuit intégré (14);
b) une couche métallique (44) située au-dessus dudit premier bras de détection (40);
c) un second bras de détection (46) situé au-dessus dudit premier bras de détection (40) pour détecter un courant entre ledit sccond bras de détection et ladite couche métallique (44); et
d) unc unité d'entrainement en z (48) pour régler la hauteur des premier et second bras de détection (40, 44).

6. Diepositif selon l'une quelconque des revendications précédentes, comprenant :

a) un circuit d'échantil1onnage et de blocage (60) branché entre ladite aiguille de détection (10) et ladite source de tension réglable (20); et
b) un faisceau (62) focalisé sur ledit circuit intégré (14) pour faciliter l'injection dudit courant dans ladite aiguille de détection (10).

7. Dispositif selon la revendication 6, dans lequel ledit faisceau (62) est un faisceau de photons.

8. Dispositif selon la revendication 6, dans lequel ledit faisceau (62) cet un faieceau d'électrons.

9. Dispositif selon la revendication 6, dans lequel lcdit faisceau (62) est un faisceau d'ions.

Fig. 1

Fig. 3

*16*

*46*

*44*

*40*

*48*

PRIOR ART

*14*

*Fig. 2a*

*16*

*46*

*44*

*40*

*48*

PRIOR ART

*14*

*Fig. 2b*

*16*

*46*

*44*

*40*

*48*

PRIOR ART

*14*

*Fig. 2c*

46

44

40

48

16

PRIOR ART

14

Fig. 2d

46

44

40

48

16

PRIOR ART

14

Fig. 2e